# FASCICULE DE BREVET EUROPEEN

(11) **EP 1 896 896 B1**
(45) Date de publication et mention de la délivrance du brevet: **13.01.2010**
(21) Numéro de dépôt: 06764740.4
(22) Date de dépôt: 06.06.2006
(51) Int. Cl.: G02F 1/39, H01S 5/183

(54) **MICRO-OSCILLATEUR PARAMÉTRIQUE OPTIQUE À CAVITÉS COUPLÉES**
OPTISCHER PARAMETRISCHER MIKROOSZILLATOR MIT GEKOPPELTEN RESONATOREN
OPTICAL PARAMETRIC MICRO-OSCILLATOR COMPRISING COUPLED CAVITIES

(30) Priorité: 06.06.2005 FR 0505708
(43) Date de publication de la demande: 12.03.2008
(73) Titulaire: CENTRE NATIONAL DE LA RECHERCHE SCIENTIFIQUE (CNRS), 75794 Paris Cedex 16 (FR); Université Paris 7 - Denis Diderot, 75251 Paris Cedex 05 (FR)
(72) Inventeur: TIGNON, Jérôme, 75012 Paris (FR); CIUTI Christiano, 92330 Sceaux (FR); DASBACH, Gregor, 48356 Coesfeld (DE); DIEDERICHS, Carole, 75013 Paris (FR)
(74) Mandataire: Novagraaf IP
(86) Numéro de dépôt international: PCT/FR2006/001280
(87) Numéro de publication internationale: WO 2006/131640

(56) Documents cités:
- FR-A- 2 751 796
- TEJA J ET AL: "Twin-beam generation in a triply resonant dual-cavity optical parametric oscillator" OPTICS EXPRESS OPT. SOC. AMERICA USA, vol. 2, no. 3, 2 février 1998 (1998-02-02), XP002363027 ISSN: 1094-4087
- J. J. BAUMBERG ET AL.: "Parametric oscillation in a vertical microcavity: A polariton condensate or micro-optical parametric oscillation" PHYSICAL REVIEW B, vol. 62, no. 24, 15 décembre 2000 (2000-12-15), pages 16247-16250, XP002363028
- WEISBUCH C ET AL: "OBSERVATION OF THE COUPLED EXCITON-PHOTON MODE SPLITTING IN A SEMICONDUCTOR QUANTUM MICROCAVITY" PHYSICAL REVIEW LETTERS, AMERICAN PHYSICAL SOCIETY, NEW YORK, US, vol. 69, no. 23, 7 décembre 1992 (1992-12-07), pages 3314-3317, XP002046379 ISSN: 0031-9007 cité dans la demande
- PELLANDINI P ET AL: "DUAL-WAVELENGTH LASER EMISSION FROM A COUPLED SEMICONDUCTOR MICROCAVITY" APPLIED PHYSICS LETTERS, AIP, AMERICAN INSTITUTE OF PHYSICS, MELVILLE, NY, US, vol. 71, no. 7, 18 août 1997 (1997-08-18), pages 864-866, XP000730201 ISSN: 0003-6951 cité dans la demande
- RIBET I ET AL: "Widely tunable single-frequency pulsed optical parametric oscillator" OPTICS LETTERS OPT. SOC. AMERICA USA, vol. 27, no. 4, 15 février 2002 (2002-02-15), pages 255-257, XP002363029 ISSN: 0146-9592

## Description

La présente invention concerne le domaine des systèmes de conversion paramétrique optique, des oscillateurs paramétriques optiques (OPO), des amplificateurs paramétriques optiques (OPA), ainsi que le domaine de la génération de photons jumeaux.

La conversion paramétrique optique obtenue dans un milieu optique non-linéaire permet par exemple de convertir des photons "pompes", injectés dans le système à une fréquence ωₚ, en paires de photons "signaux" et "complémentaires" (ou « idler » en langue anglaise) à des fréquences différentes ωₛ et ωᵢ. Elle permet la génération de photons jumeaux, la génération de nouvelles fréquences (pour l'OPO) ou l'amplification de signaux faibles (pour l'OPA). Cet effet est amplifié lorsque le milieu non-linéaire est placé au sein d'une cavité résonante de façon à produire un oscillateur. Il est connu que quand la cavité, est proche de la résonance pour le "signal" et le "complémentaire" (OPO doublement résonant, ou DROPO) ou pour les trois ondes (OPO triplement résonant, ou TROPO), le seuil pour la génération paramétrique peut être considérablement diminué, ce qui accroît considérablement l'efficacité du mécanisme. On notera qu'un tel système peut généralement fonctionner sous excitation impulsionnelle. Les OPO sont des sources de lumière cohérente dans lesquelles la génération des nouvelles fréquences est spontanée au dessus d'un seuil de puissance de la "pompe,". Les OPA, dans lesquels la génération n'est pas spontanée, sont utilisés pour leur capacité à amplifier des faisceaux lumineux, de faible intensité, à la fréquence ωₛ ou ωᵢ. La nature du milieu non-linéaire ainsi que le dessin des cavités détermine les fréquences ωₛ et ωᵢ. Pour un milieu actif présentant une susceptibilité non-linéaire de type χ⁽²⁾, la conservation de l'énergie conduit à la relation ωₚ=ωₛ +ωᵢ. Pour un milieu de type χ⁽³⁾, la relation est 2ωₚ=ωₛ+ωᵢ. Dans les deux cas, une conversion paramétrique efficace requiert d'optimiser la condition d'accord de phase qui s'écrit : Δk=kₚ-kᵢ-kₛ=0 pour un système de type χ⁽²⁾ ou Δk=2kₚ-kᵢ-kₛ=0 pour un système de type χ⁽³⁾.

L'art antérieur connaît des systèmes, monolithiques ou non, de conversion paramétrique à l'aide de cavités pour obtenir une multi-résonance. Le problème avec les OPO classiques non monolithiques tels que ceux décrits dans le document de Teja "Twin-beam generation in a triply resonant dual-cavity optical parametric oscillator" est leur encombrement et leur complexité parce qu'ils requièrent un laser de pompe, un cristal non-linéaire et des miroirs externes pour les cavités. La difficulté pour obtenir une conversion paramétrique efficace est liée au besoin de satisfaire à ce qui est connu par l'homme du métier comme la condition d'accord de phase d'une part et d'autre part la nécessité d'obtenir des modes de cavité résonant avec les fréquences paramétriques. Concernant les systèmes monolithiques, on distingue deux situations très différentes selon que la non-linéarité soit en χ⁽²⁾ ou χ⁽³⁾.

La publication de Savvidis, Baumberg, Stevenson, Skolnick, Whittaker et Roberts "Angle-Resonant Stimulated Polariton Amplifier", publiée dans Physical Review Letters, Vol 84, page 1547, Février 2000, divulgue un système pour l'amplification paramétrique par le moyen d'une seule microcavité planaire. Le champ électromagnétique est entièrement confiné par la cavité selon la direction de croissance et est de surcroît en régime de couplage fort exciton-photon avec le système de puits quantiques placé en son sein. Dans ce système, la susceptibilité χ⁽³⁾ est très importante et permet d'obtenir une conversion paramétrique efficace pour des fréquences ωₚ, ωₛ, et ωᵢ proches, toutes inclues la bande d'arrêt des miroirs de Bragg. La cavité unique, en régime de couplage fort exciton-photon, permet ici d'obtenir une résonance triple pour les trois fréquences. Néanmoins, le respect de la condition d'accord de phase requiert que l'injection des photons pompe se fasse à un angle particulier, de grande valeur (typiquement 16°) et délicat à déterminer, ce qui rend difficile toute utilisation pratique. De plus, les photons complémentaires sont émis à un angle plus important encore, angle pour lequel le couplage des photons avec l'extérieur de la cavité est particulièrement faible, ce qui rend difficile la génération de photons jumeaux. Enfin, le régime de couplage fort exciton-photon étant essentiel à l'obtention de l'accord de phase, le système ne fonctionne, avec les matériaux disponibles pour la fabrication, comme GaAs, qu'à basse température.

Le document de Baumberg et al. « Parametric oscillation in a vertical microcavity : a polariton condensate or micro-optical parametric oscillation », décrit un système monolithique selon le préambule de l'objet de la revendication 1.

Le système décrit dans ce document comprend également une unique cavité et présente les inconvénients mentionnés ci-dessus.

D'autre part, pour les systèmes utilisant une non-linéarité en χ⁽²⁾, la publication de Haïdar, Forget et Rosencher, "Optical Parametric Oscillation in Microcavities Based on Isotropic Semiconductors: a Theoretical Study", publiée dans IEEE Journal of Quantum Electronics, Vol 30, N°4, Avril 2003, divulgue un système pour l'oscillation paramétrique dans lequel le diagramme de réflectivité des miroirs utilisés est tel qu'illustré figure 1. Ce document divulgue un dispositif dans lequel les fréquences ωₚ, ωₛ et ωᵢ sont très différentes et ne peuvent pas être toutes incluses dans la bande d'arrêt d'un seul miroir de Bragg. La condition de résonance est alors cherchée pour le signal et le complémentaire à l'aide de deux cavités non fortement couplées entre elles au sens défini plus loin.

On connaît également la demande de brevet FR 2 751 796, au nom du CEA, qui décrit un système de deux lasers couplés dans lequel un premier laser pompe un second laser. Les cavités laser de ce document ne sont toutefois pas agencées pour générer des fréquences paramétriques. En effet, le système décrit dans D1 n'est pas un oscillateur paramétrique, mais un simple laser. En particulier, ce document ne décrit pas la nature du couplage entre les cavités laser et ne permet pas de générer des fréquences paramétriques.

Un but de la présente invention est de fournir une solution alternative aux systèmes de conversion paramétrique existants pour réaliser facilement la conversion paramétrique.

Un autre but de la présente invention est de permettre la conversion paramétrique pour des fréquences proches, au sens défini plus loin, entre la pompe, le signal et le complémentaire ou au moins pour des fréquences proches entre deux des trois fréquences paramétriques.

Un autre but de la présente invention est de réaliser un système de conversion paramétrique vertical pour un angle d'injection de la pompe selon l'axe du système.

Pour résoudre au moins un de ces problèmes, la présente invention concerne un système selon la revendication 1.

Aux fins de la présente demande, et comme le comprendra l'homme du métier, le terme « cavités fortement couplées entre elles » correspond à la levée de dégénérescence des modes de cavité résonantes.

On note également que la direction de l'injection de l'onde de pompe est réalisée « par la surface » du système. En effet, le système selon l'invention comprend une pluralité de couches selon des plans sensiblement parallèles et formant un système monolithique. L'injection est alors réalisée selon ces plans et non par la tranche de ces couches comme dans des systèmes connus. Le système selon l'invention est donc connu de l'homme du métier comme étant un système à injection verticale, par opposition à une injection par la tranche. De même, le système selon l'invention est un système à émission par la surface.

De la sorte, les modes propres du système couplé réalisent un ensemble de mode optiques multi-résonant pour les fréquences paramétriques.

Selon un premier mode de réalisation, le matériau non linéaire présente une susceptibilité de type χ⁽³⁾ permettant de générer des photons signal et complémentaire à des fréquences proches de la pompe.

Selon un second mode de réalisation, le matériau présente une susceptibilité de type χ⁽²⁾ permettant une conversion dans laquelle deux des trois fréquences paramétriques seront proches entre elles.

Aux fins de la présente demande, le terme « fréquences proches » correspond à des fréquences incluses dans la bande d'arrêt du miroir de Bragg.

Selon un premier mode de mise en oeuvre, pour l'obtention d'un dispositif triplement résonant, le système susmentionné peut comprendre trois cavités résonnantes, lesdites cavités étant fortement couplées par deux miroirs de couplage, lesdites cavités étant agencées pour générer trois fréquences paramétriques associées à ladite fréquences de pompe, ledit système comprenant deux miroirs qui ferment le système et qui forment lesdites cavités avec lesdits deux miroirs de couplage.

Selon un second mode de mise en oeuvre, pour l'obtention d'un dispositif doublement résonant, ledit système peut comprendre deux cavités résonnantes, lesdites cavités étant fortement couplées par un miroir de couplage, lesdites cavités étant agencées pour générer trois fréquences paramétriques associées à ladite fréquences de pompe, ledit système comprenant deux miroirs qui ferment le système et qui forment lesdites cavités avec ledit miroir de couplage.
Le milieu non linéaire actif peut être soit un puits quantique, soit un système de boîtes quantiques, ou bien un matériau massif, par exemple un semi-conducteur ou un polymère, ou tout autre milieu actif solide.

Les miroirs de couplage utilisés sont de préférence des miroirs de Bragg, ou bien une couche diélectrique ou métallique possédant les paramètres de réflectivité adaptés à la présente invention.

Selon un mode de réalisation possible, ladite au moins une cavité est d'épaisseur sensiblement égale à un petit nombre entier de fois la demi-longueur d'onde de l'onde de pompe que l'on désire convertir, et ce, afin que le champ soit suffisamment intense dans la cavité.

Avantageusement, le système de conversion paramétrique selon la présente invention permet d'obtenir la condition d'accord de phase pour le cas d'un régime de couplage faible lumière-matière et aussi pour le cas d'un régime de couplage fort lumière-matière (photon-exciton).

Si la méthode de croissance n'est pas assez précise pour viser les épaisseurs nominales et afin d'ajuster finement la condition de résonance entre les modes de cavité et les fréquences paramétriques, l'épaisseur d'au moins une cavité présente éventuellement un gradient latéral, c'est-à-dire dans le plan normal à la direction de l'axe de croissance pour un systèmes vertical.

De préférence, si la méthode de croissance n'est pas assez précise pour viser les épaisseurs nominales et afin d'ajuster finement la condition de résonance entre les modes de cavité et les fréquences paramétriques, l'épaisseur d'une des cavités présente un gradient latéral dans une première direction, et une seconde cavité présence un gradient latéral dans une seconde direction différente de ladite première direction, par exemple perpendiculaire, dans plan normal à la direction de l'axe de croissance.

Par ailleurs, afin d'obtenir un mode lumineux plus isotrope, et par opposition aux dispositif donnant une émission par la tranche de la structure, le système selon l'invention est à émission par la surface. Ceci possède également l'avantage de pouvoir tester les composants avant la découpe et de pouvoir éventuellement paralléliser la fabrication ou l'utilisation d'un grand nombre de composantes de même nature. Ce type de géométrie permet aussi un couplage aisé à des fibres optiques.

Selon une technique de croissance avantageuse dans le domaine des microstructures, le coeur des cavités et/ou certains miroirs de Bragg sont épitaxiés.

L'invention concerne également un dispositif optique destiné à la réalisation de conversion paramétrique comprenant un système tel que décrit ci-dessus, le dispositif comprenant en outre un moyen d'injection d'une onde de pompe à une longueur d'onde de pompe, ledit moyen d'injection étant apte à injecter ladite onde de pompe sensiblement selon l'axe dudit système.

Avantageusement, selon un mode de réalisation et afin d'obtenir un dispositif compact ledit moyen d'injection est formé par une cavité dite d'injection, solidaire dudit système et faiblement couplé à celui-ci par un miroir de couplage faible pour ladite longueur d'onde de pompe.

Avantageusement, la cavité, dite d'infection peut être extérieur au système tel que décrit ci-dessus et peut être attachée après la croissance du système par la technique connue sous le nom de « wafer bonding ».

Avantageusement, la cavité dite d'injection peut être fabriquée selon les techniques de l'art antérieur pour la fabrication des VCSEL de façon à autoriser une injection électrique de celle-ci.

Avantageusement et selon un autre mode de réalisation d'un système compact, la cavité d'injection peut être l'une des cavités utilisée pour la réalisation du système de conversion paramétrique.

On comprendra mieux l'invention à l'aide de la description, faite ci-après à titre purement explicatif d'un mode de réalisation de l'invention, en référence aux figures annexées :

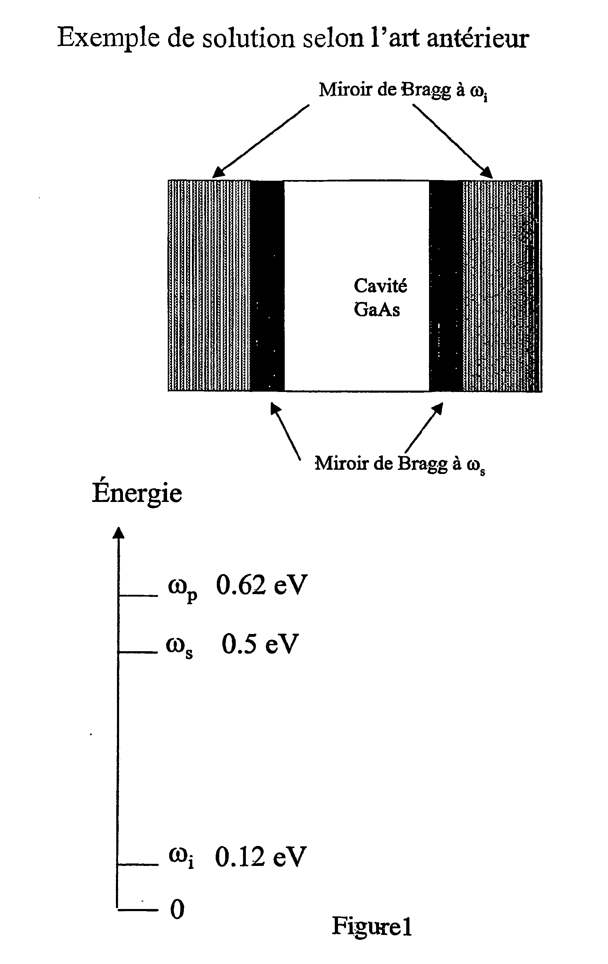

- la figure 1 illustre le schéma de principe d'un système de conversion paramétrique selon l'art antérieur et le diagramme des fréquences paramétriques selon l'art antérieur ;
- la figure 2 illustre un mode de réalisation, du système de conversion paramétrique selon l'invention ;
- la figure 3A illustre la structure, diélectrique selon l'invention le mode de réalisation présenté figure 2 ;
- la figure 3B illustre le diagramme de réflectivité de la structure diélectrique de la figure 3A ;
- la figure 4 illustre un diagramme de réflectivité calculé par la méthode standard des matrices de transfert, dans lequel l'accord de phase est obtenu par le système selon l'invention, entre les trois états de plus basse énergie, à l'angle nul ;
- la figure 5 illustre un accord de phase obtenue par le système selon l'invention pour un angle d'émission non nul et permettant de réaliser une intrication ;
- la figure 6 illustre, selon le mode de réalisation illustré figure 2, la mesure de l'émission sous excitation non résonante (courbe de gauche) ainsi que l'émission mesurée sous excitation résonante du mode de pompe (courbe de droite), avec mise en évidence du couple signal/complémentaire ;
- la figure 7 illustre les résultats de conversion paramétrique obtenus grâce au système selon l'invention illustré figure 2. La courbe de gauche représentée le spectre mesuré (angle nul) sous excitation non-résonante et sous excitation résonante. Les deux courbes de droite représentent l'intensité émise par le signal ou le complémentaire en fonction du paramètre « x » d'accord de phase (pris dans le régime linéaire) ;
- la figure 8 illustre un second mode de réalisation du système de conversion paramétrique selon l'invention ;
- la figure 9 illustre un Dispositif de conversion paramétrique dans lequel un moyen d'injection contacté électriquement est intégré au système de conversion.

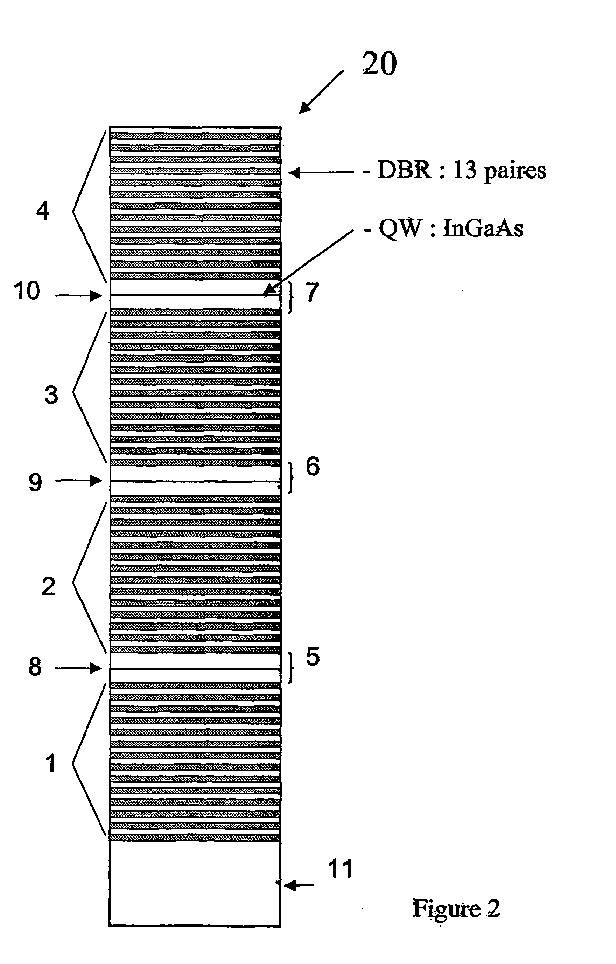

Selon un mode de réalisation illustré figure 2, l'invention concerne un système 20 de conversion paramétrique pour convertir une fréquence de pompe, en une fréquence signal et une fréquence complémentaire. Ce système est formé d'une structure comprenant par exemple trois cavités résonantes de type Fabry-Pérot 5, 6 et 7 en GaAs. Il comprend également un substrat 11. Il est avantageux d'utiliser des cavités de faible épaisseur, par exemple un faible multiple de la demi-longueur d'onde de façon à obtenir une forte amplitude du champ électrique au ventre du champ où sera placé le matériau actif (micro-cavité).

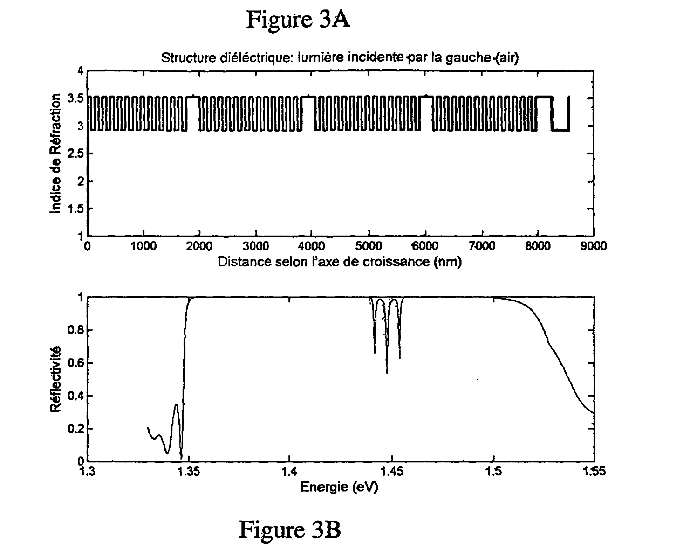

Selon l'exemple présenté, chaque cavité est d'épaisseur égale à une fois la longueur d'onde. Chacune des cavités est enserrée par deux miroirs à réflexion de Bragg 1 et 2 pour la cavité 5; 2 et 3 pour la cavité 6, et 3 et 4 pour la cavité 7. Les miroirs consistent en un empilement répété de deux couches transparentes, d'indices différentes et d'épaisseur permettant d'obtenir la réflectivité désirée pour le fonctionnement du dispositif. L'épaisseur est alors par exemple égale au quart de la longueur d'onde de pompe pour chacune des couches. Plus précisément, dans l'exemple illustré figure 2 ou figure 3A, les miroirs de Bragg sont chacun constitués de 13 paires de couches d'AlAs en alternance avec des couches de GaAs. La réflectivité des miroirs de Bragg 1, 2 et 3, illustrée figure 3B est légèrement inférieure à l'unité de sortie que les cavités, sont couplées entre elles.

Plus précisément, les cavités 5 et 6 sont couplées, fortement par l'intermédiaire du miroir de Bragg 2 et les cavités 6 et 7 sont couplées fortement par l'intermédiaire du miroir de Bragg 3. Comme le comprendra l'homme du métier, pour un système de deux cavités, le couplage fort est obtenus lorsque la réflectivité du miroir de couplage est inférieure à 4R/(1+R)², où R est la réflectivité des miroirs qui enserrent l'ensemble des deux cavités. Dans un cas plus général, il est aisé de déterminer la réflectivité et donc le nombre de couches nécessaires pour obtenir un miroirs de couplage fort, en effectuant le calcul de la réflectivité par la méthode standard des matrices de transfert.

La figure 3B illustre le diagramme de réflectivité des miroirs selon la figure 2 pour laquelle les trois modes fortement couplés et résonants avec les fréquences paramétriques pour un matériau en χ⁽³⁾ apparaissent (à 7 meV d'intervalle) au centre de la bande d'arrêt des miroirs de Bragg.

L'ensemble est ici couplé à l'extérieur au travers des miroirs de Bragg 1 et 4.

Individuellement, chacune de ces cavités se présente sous la forme de structure de type connu et dont la fabrication est maîtrisée par l'homme du métier pour réaliser les lasers semi-conducteurs à cavité verticale, comme ceci est par exemple décrit dans les publications de J.L. Jewell, J.P. Harbison, A. Sherer, Y.H. Lee, L.T. Florez, "Vertical-cavity surface-emitting lasers - design, growth, fabrication, characterization ", IEEE J. Quantum Electron. QE-27, p 1332 (1991) et de M. Shimada, T. Asaka, Y. Yamasaki, H. Iwano, M. Ogura, S. Mukai, "Low-threshold surface-emitting lasers-diodes with distributed Bragg reflectors and current blocking layers", Appl. Phys. Lett. 57, p 1289 (1990), ou pour réaliser les systèmes de deux cavités couplées, comme ceci est décrit dans Les publications de P. Michler, M. Hilpert, G. Reiner, "Dynamics of dual-wavelength emission from a coupled semiconductor microcavity laser", Appl. Phys. Lett. 70, p 2073 (1997), et de P. Pellandini, R.P. Stanley, R. Houdré, U. Oesterle, M. Ilegems, C. Weisbuch, "Dual-wavelength émission from a coupled semiconductor microcavity", Appl. Phys. Lett. 71, p864 (1997).

En dehors du couplage inter-cavités, chaque cavité possède un mode propre de type Fabry-Pérot ayant une énergie du mode notée w(k) qui croît rapidement en fonction du vecteur d'onde dans le plan des couches k, ou de façon équivalente en fonction de l'angle d'incidence, l'un et l'autre étant reliés par une relation trigonométrique simple.

Lorsque les cavités ont la même épaisseur, le couplage inter-cavités lève la dégénérescence entre Les trois modes, dans la mesure où le couplage entre cavités est supérieur à la largeur spectrale des modes.

Il en résulte l'apparition de 3 nouveaux modes propres qui correspondent à des modes photoniques délocalisés dans toute la structure et non plus localisés dans chacune des cavités.

Dans ce mode de réalisation de l'invention, on positionne un milieu non-linéaire actif formé par exemple par un ensemble de puits quantiques 8, 9, 10, au sein des cavités, au voisinage des maxima du champ électrique.

La transition excitonique fondamentale est ici à une énergie voisine de la résonance avec les microcavités. Melon une variante simple, on place par exemple un puits quantique unique d'InGaAs (à 6% d'In) au centre de chacune des trois cavités, étant entendu qu'augmentation du nombre de puits quantiques permet d'augmenter la non-linéarité.

De la sorte, on obtient une contribution importante des non-linéarités à chacun des modes propres du système, favorisant ainsi l'existence d'un seuil à basse puissance d'excitation pour les oscillations paramétriques, par distinction avec une non-linéarité non-résonante, lorsque le fonctionnement se fait dans la zone de transparence du milieu non-linéaire.

Le système 20 constitue donc un ensemble de 6 oscillateurs couplés (3 modes photoniques et 3 excitons). Suivant les conditions de température et de puissante d'excitation, le couplage matière-rayonnement correspond alors soit à un régime de couplage faible exciton-photon, soit à un régime de couplage fort exciton-photon, lorsque la force du couplage prédomine devant les pertes.

En régime de couplage faible, le système se caractérise ici, par l'existence dans le spectre de 3 résonances (les 3 modes photoniques élargis par l'absorption excitonique). On choisit alors respectivement ces trois résonances pour l'injection dans l'état "pompe" et l'émission par les états "signaux" et "complémentaires".

En régime de couplage fort, la dégénérescence entre photons et excitons est levée et le spectre présente alors 6 nouveaux modes propres, états mixtes excitons-photons appelés les polaritons de microcavité. Dans ce cas, les états "pompes", "signaux" et "complémentaires" seront sélectionnés parmi 3 des 6 modes propres, selon la configuration la plus avantageuse en terme de gain pour l'oscillation paramétrique.

Notons que, contrairement à l'oscillation paramétrique obtenue pour des cavités uniques, le principe de fonctionnement n'est plus limité par la nature du couplage, (faible ou fort) matière-rayonnement, et l'oscillation paramétrique peut être atteinte, quelque soit le type de couplage matière-rayonnement.

Selon un principe déjà connu, le régime d'oscillation paramétrique peut être obtenu à condition de satisfaire à la conservation de l'énergie et de l'impulsion (ou du vecteur d'onde) entre les photons injectés dans l'état de "pompe" et les photons émis dans les états "signaux" et "complémentaires", ce qui constitue la condition d'accord de phase.

La conservation de l'énergie est satisfaite à condition de sélectionner 3 états équidistants en énergie, de façon à respecter la condition 2ωₚ = ωₛ + ω_{c} (pour un processus non-linéaire du 3^{éme} ordre), où ωₚ est l'énergie de la pompe, ωₛ l'énergie du signal et ω_{c} l'énergie du complémentaire (ωₛ < ωₚ < ω_{c}).

De même, la conservation de l'impulsion est satisfaite à condition de respecter la relation 2kₚ = kₛ + k_{c} où kₚ est le vecteur d'onde de la pompe, kₛ le vecteur d'onde du signal et k_{c} le vecteur d'onde du complémentaire.

Selon une variante avantageuse de l'invention, un gradient d'épaisseur est introduit dans une ou plusieurs cavités de façon à pouvoir obtenir l'accord de phase à angle nul pour les états "pompe", "signal" et "complémentaire". L'introduction d'un gradient peut se faire par interruption sélective de la rotation du wafer lors de la croissance, selon un principe analogue à ce qui est connu pour les cavités planaires uniques, par exemple décrit dans la publication de C. Weisbuch, M. Nishioka, A. Ishikawa, and Y. Arakawa, "Observation of the coupled exciton-photon mode splitting in a semiconductor quantum microcavity", Phys. Rev. Lett. 69, p3314 (1992).

En particulier, il est possible d'introduire un gradient (environ 1 meV/mm) dans des directions perpendiculaires pour deux des trois cavités, ce qui permet d'ajuster l'énergie des trois cavités indépendamment. Pour cela, la rotation du wafer est interrompue lors de la croissance de la première cavité (premier gradient d'épaisseur), puis interrompue, pour la seconde cavité, selon une direction perpendiculaire à celle choisie pour la première cavité (second gradient d'épaisseur perpendiculaire au premier). La rotation est de nouveau interrompue pour la troisième cavité selon la même direction que pour la première. On peut ainsi, en se déplaçant à la surface de l'échantillon, ajuster le désaccord relatif entre les états de "pompe","signal" et "complémentaire" pour ajuster la condition de conservation de l'énergie.

La conservation de l'impulsion s'obtient alors naturellement pour une excitation avec un angle d'incidence nul, c'est-à-dire une injection perpendiculaire à la surface de l'échantillon lorsque les énergies respectent la condition 2ωₚ(kₚ=0) = ωₛ(kₛ=0) + ω_{c}(k_{c}=0).

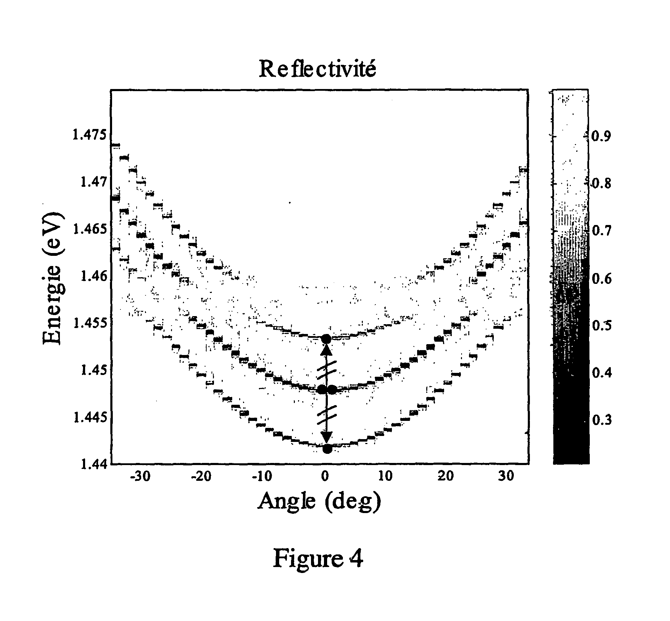

Le diagramme de réflectivité associé à une telle configuration est représenté schématiquement sur la Figure 4, dans laquelle la dispersion est calculée par la méthode standard des matrices de transfert et l'excitation est symbolisée sur le 2^{éme} mode où deux photons sont injectés, un photon est émis par le "signal" et un photon est émis par le "complémentaire".

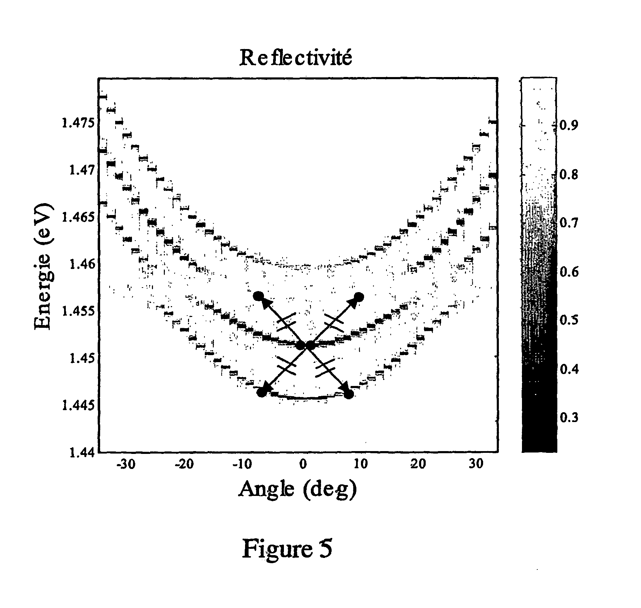

Il est aussi possible, en se déplaçant sur l'échantillon, d'obtenir un accord de phase pour des angles non-nuls. Le diagramme de réflectivité associé à une telle configuration est présentée schématiquement sur la Figure 5. Cette dernière configuration ne produisant pas de modes "signaux" et "complémentaires" uniques, elle n'est pas favorable pour l'obtention d'une oscillation paramétrique, mais peut néanmoins permettre d'observer une émission de modes intriqués sur un anneaux dans un plan perpendiculaire à l'axe de croissance, selon un mécanisme analogue à celui prédit pour des fils photoniques dans une émission de type fluorescence paramétrique.

On peut mettre en évidence l'effet décrit ci-dessus par un montage connu dans le domaine de l'émission pour des nanostructures de semi-conducteurs. Le dispositif comprend une source laser pour l'excitation, par exemple de type Titane-saphir accordable en fréquence. L'excitation est effectuée en régime continu, par la surface de l'échantillon, après localisation sur un spot d'environ 20 micromètres de diamètre.

Pour l'étude du dispositif, on place un échantillon dans un cryostat à Hélium. Des résultats positifs ont été obtenus par le Demandeur avec le dispositif illustré figure 2 dans une gamme de température entre 6K et 90K.

Cependant il est entendu qu'on peut envisage d'étendre l'utilisation de la présence invention jusqu'à la température ambiante selon le même principe.

En mode opératoire, le substrat a été aminci par une méthode standard de ponçage mécanique, de façon à pouvoir réaliser des mesures optiques en transmission aussi bien qu'en réflexion. L'émission est collectée en transmission, à l'aide d'une fibre optique montée sur un goniomètre afin d'effectuer l'analyse angulaire de l'émission. Le rayonnement émis est détecté par un analyseur multicanal à photodiodes placé en sortie d'un spectromètre ayant une résolution de 100 micro-eV.

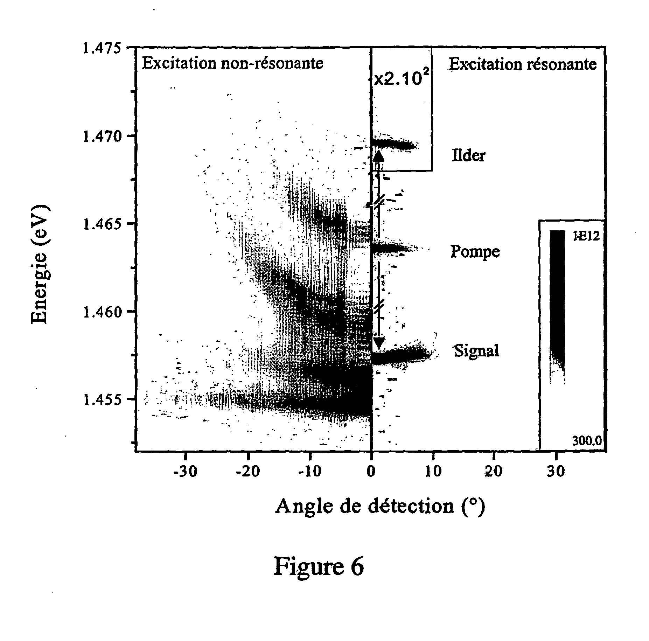

La Figure 6 représente l'émission (photoluminescence) mesurée en fonction de l'angle de détection, pour une excitation non-résonante (partie de la figure à gauche). Le diagramme d'émission reflète alors la dispersion en fonction du vecteur d'onde dans le plan des couches (ou de façon équivalente en fonction de l'angle). Jusqu'à 5 modes sont visibles sur cette figure. Une analyste détaillé des résultats expérimentaux permet de mettre en évidence la coexistence de 6 modes. Le système, dans le cas de l'excitation non-résonante, est en régime de couplage fort entre excitons et photons. La partie à droite de la Figure 6 représente la mesure de l'émission sous excitation résonante continue d'un des 6 modes et sous angle d'incidence nul (état "pompe"), pour une position sur l'échantillon où l'accord de phase est obtenu entre 3 états à angle nul. Au-delà d'une puissance d'excitation seuil de 200 mW, l'émission de l'état de basse énergie (signal) et de l'état de haute énergie (complémentaire) croissent de façon exponentielle.

On note que le Demandeur a pu vérifier expérimentalement que la polarisation du "signal" et du "complémentaire" respecte les règnes de sélection imposées par le mécanisme paramétrique (émission co-circulaire droite ou gauche pour une excitation co-circulaire droite ou gauche).

On note que le Demandeur a pu vérifieur expérimentalement que le dispositif selon l'invention permettait aussi d'obtenir l'amplification paramétrique d'un second faisceau laser continu, de faible intensité, injecté dans le système à la fréquence du signal.

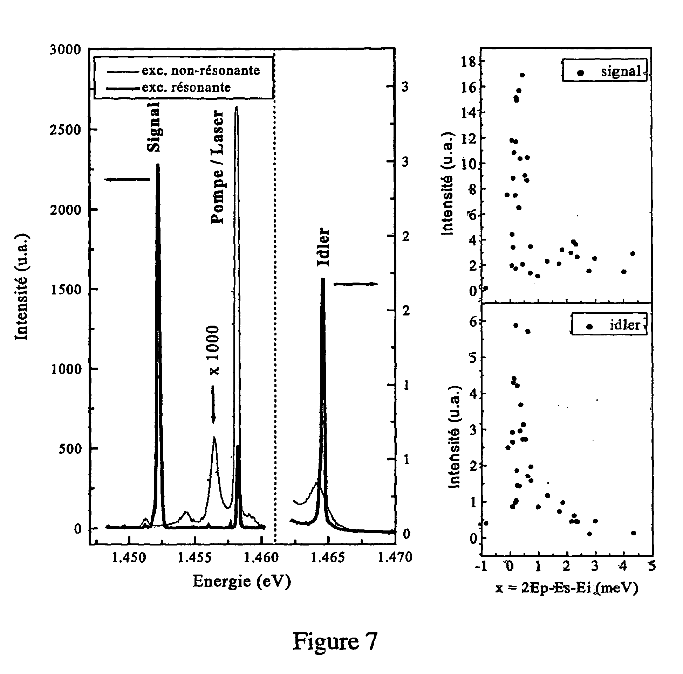

La Figure 7 (courbes de gauche) représente le spectre de l'émission sous le seuil (trait fin noir) et au dessus du seuil (trait gras) pour l'oscillation paramétrique. En plus de l'augmentation considérable de l'émission pour le "signal" et le "complémentaire" au delà du seuil, on observe clairement l'affinement des transitions (le "signal" s'affine de 0.7 meV à moins de 0.2 meV et le "complémentaire" de 1.5 meV à moins de 0.2 meV, proche de la limite de résolution de la mesure). On observe de même au-delà du seuil un léger décalage vers les hautes énergies caractéristiques du régime d'oscillation paramétrique.

On notera qu'en dehors du mécanisme de diffusion représenté sur la Figure 5, qui permet à deux photons injectés sur la deuxième branche d'être converties en photons sur la première branche à basse énergie, et sur la troisième branche à haute énergie, il existe toujours un autre mécanisme de diffusion paramétrique, non représenté. Cet autre mécanisme correspond à la possibilité pour les photons injectés sur la deuxième branche, d'être diffusés à énergie constante, sur la première branche, la même branche basse énergie pour les deux photons diffusés. Les deux photons sont alors diffusés respectivement en -k et en +k. Par rapport à la situation représentée sur la Figure 5, on peut représenter ce mécanisme comme un cas limite dans lequel tous les photons diffusés conservent l'énergie initiale. Ce mécanisme est le seul possible si l'accord de phase, donc la position sur l'échantillon, ne permet pas d'obtenir ni la diffusion paramétrique représentée sur la Figure 4, ni la diffusion paramétrique représentée sur la Figure 5. En outre, ce mécanisme ne requiert intrinsèquement que deux branches et peut donc être obtenu dans un système à deux cavités seulement. On notera que ce mécanisme, s'il n'offre aucun intérêt pour la génération de nouvelles fréquences, présente un intérêt non négligeable pour la génération de photons jumeaux en vue de réaliser une source pour l'optiques quantique et les systèmes de cryptographie. En effet, dans ce cas, les deux photons émis sont intrinsèquement couplés à l'extérieur de la même manière et offriront donc la même intensité en émission. D'autre part, l'émission s'effectuant à des angles importants, il sera aisé de séparer les photons jumeaux émis.

Par ailleurs, on a décrit ici un choix technique, où l'on a minimisé le nombre de couches dans les miroirs de Bragg (13 paires) et le nombre de puits quantique (1 puits par cavité) afin de réduire le temps de croissance et de minimiser une possible inhomogénéité (par exemple sur la largeur des puits quantiques et donc sur l'énergie des puits les uns par rapport aux autres).

Le nombre de paires de couches dans Les miroirs de Bragg influe sur deux paramètres dans la présente invention : la finesse des modes photoniques et l'importance du couplage entre les cavités. Il est connu d'après l'état des connaissances sur les cavités uniques planaires que le seuil pour l'oscillation paramétrique est d'autant plus faible que la finesse est grande. Inversement, il est important ici d'obtenir un bon couplage entre les trois cavités et donc de réduire le nombre de couches pour les miroirs intermédiaires 2 et 3.

On peut également envisager d'optimiser la structure en développant une structure ayant un plus grand nombre de paires pour les miroirs extérieurs 1 et 4, afin d'accroître la finesse globale, tout en minimisant le nombre de paires dans les miroirs de couplage 2 et 3.

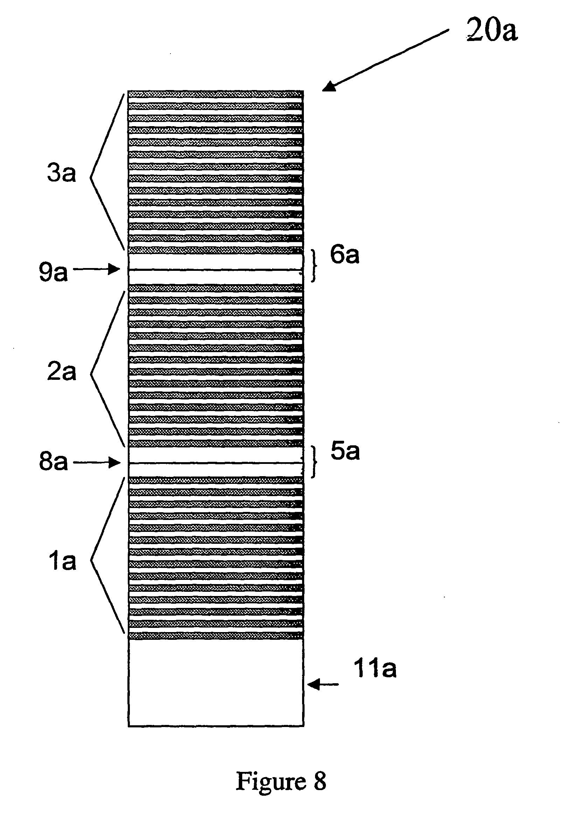

Selon un second mode de réalisation, on réalise un système 20a comprenant seulement deux cavités couplées, comme illustré figure 8. Il comprend donc deux cavités 6a, 5a, un miroir de couplage 2a et deux miroirs 3a et 1a qui ferment le système et qui forment les cavités 6a, 5a avec le miroir de couplage 2a. Chaque cavités contient par exemple, comme précédemment, un puit quantique de type In_{0,06}Ga_{0,94}AS 8a et 9a. Le substrat est noté 11a. Ce mode de réalisation est adapté aussi bien pour l'utilisation d'un milieu en χ⁽³⁾ que pour un milieu en χ⁽²⁾, les deux cavités étant alors utilisées pour obtenir une résonance pour le signal et le complémentaire uniquement. Dans ce dernier cas, l'épaisseur des couches est choisie telle que l'énergie des cavités couplées soit dans la zone de transparence du matériau formant la cavité (par exemple GaAs). Pour une non-linéarité en χ⁽²⁾, le pompage se fait à une énergie supérieure au signal et au complémentaire.

L'invention concerne également un Dispositif due conversion paramétrique comprenant un système tel que décrit dans les modes de réalisation précédents ainsi qu'un moyen d'injection pour la pompe à la fréquence de la pompe.

Selon une première variante, le moyen d'injection est par exemple de type laser et est agencé de sorte que l'angle d'injection, dans le système selon l'invention, soit sensiblement nul. Conformément à l'invention, on réalise alors une conversion paramétrique et la génération d'un photon signal et complémentaire.

Selon une seconde variante, le moyen d'injection est intégré au système selon l'invention et se présente sous la forme d'une cavité additionnelle faiblement couplé pour la longueur d'onde de pompe, par un miroir de couplage faible présentant par exemple une plus grande réflectivité.

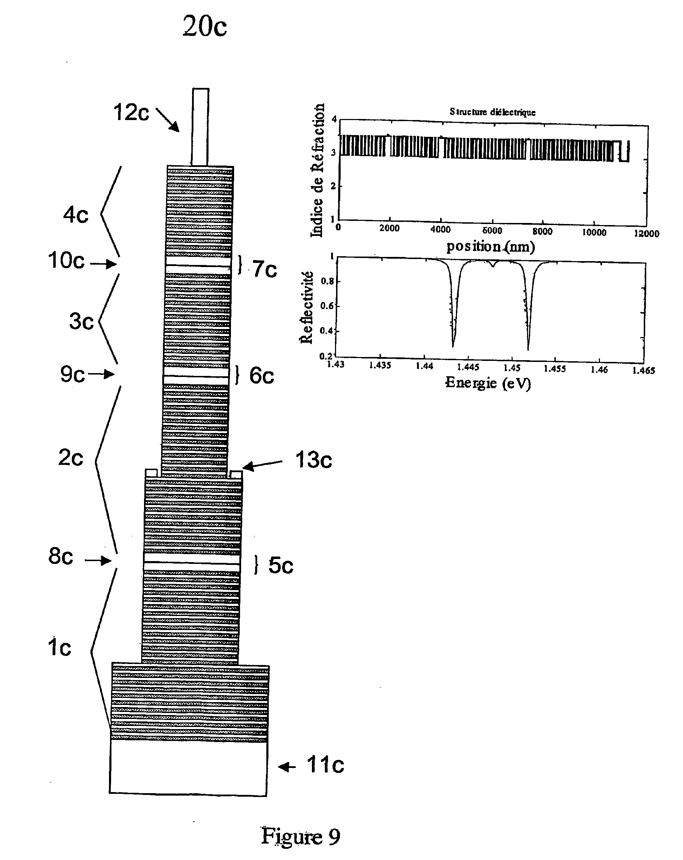

Un mode de réalisation pour un dispositif comprenant un moyen d'injection électrique, noté 20c, est présenté sur la figure 9. Les cavités 6c et 7c sont fortement couplées par l'intermédiaire du miroir de couplage 3c, qui comprenant 13 paires de couches AlAs/GaAs dans l'exemple présenté. Ces deux cavités fortement couplées fournissent les résonances pour le signal et le complémentaire. La troisième cavité, dite cavité d'injection, notée 5c, est faiblement couplée aux deux autres cavités par l'intermédiaire du miroir 2c qui comprend 23 paires de couches dans l'exemple présenté. Le spectre de réflectivité calculé, correspondant à cette structure, est présenté sur la partie droite de la figure 9. Le mode à basse énergie est le mode signal, le mode haute énergie le complémentaire et le mode intermédiaire est le mode correspondant à la cavité d'injection 5c. La cavité d'injection est contactée électriquement selon les moyens connus par l'homme du métier. Pour cela, les miroirs 2c et 1c sont dopés, puis contactés électriquement 13c. Le dispositif peut être couplé à une fibre optique notée 12c pour collecter les deux fréquences paramétriques. Le substrat est ici noté 11c.

Plusieurs utilisations du dispositif sont possibles. Le dispositif étant capable de fonctionner dans le régime d'amplification paramétrique, il peut être utilisé dans le domaine des télécommunications pour la régénération des signaux faibles.

Pour le mode de réalisation faisant appel à une non-linéarité en χ⁽²⁾, la génération paramétrique permet d'obtenir des fréquences environ deux fois plus faibles que celle de la pompe, dans une gamme spectrale difficilement accessible par les diodes lasers classiques.

La génération paramétrique de photons jumeaux est à la base de procédés de cryptographie et servent de substitut à l'utilisation des sources de photons uniques. Dans ce cadre, les photons émis par le complémentaire servent à trigger la détection des photons signaux. Toute interception d'un photon par une tierce partie est systématiquement détectée. De surcroît, la génération paramétrique coffre un avantage supplémentaire par rapport aux sources de photons uniques, à savoir la possibilité de générer des états intriquées, tels que ceux présentés dans la figure 5. différents modes de cryptographie quantique sont décrits dans la publication de N. Gisin, G. Ribordy, W. Tittel et H. Zbinden, "Quantum cryptographie", Rev. Mod. Phys., p 145 (2002).

## Revendications

1. Système (S) monolithique, pour la conversion paramétrique à partir d'une onde de pompe à une fréquence de pompe, le systéme étant **caractérisé en ce qu'**il comprend au moins deux cavités résonantes (6, 7), lesdites cavités étant fortement couplées par au moins un miroir de couplage (3) de sorte à lever la dégénerescence des modes de cavité résonnante dans lesdites cavités, lesdites cavités étant agencées pour générer des fréquences paramétriques associées à ladite fréquences de pompe, au moins une desdites cavités comprenant un milieu non linéaire actif, ledit au moins un miroir de couplage étant agencé de sorte que lesdites fréquences paramétriques soient situées dans la bande d'arrêt dudit au moins un miroir pour une direction d'injection de ladite onde de pompe par la surface dudit système.

2. Système (S) de conversion paramétrique selon la revendication 1, **caractérisé en ce qu'**il comprend trois cavités résonnantes, lesdites cavités étant fortement couplées par deux miroirs de couplage de sorte à lever la dégénerescence des modes de cavité résonnante dans lesdites cavités, lesdites cavités étant agencées pour générer trois fréquences paramétriques associées à ladite fréquence de pompe, ledit système comprenant deux miroirs qui ferment le système et qui forment lesdites cavités avec lesdits deux miroirs de couplage.

3. Système (S) de conversion paramétrique selon la revendication 1, **caractérisé en ce qu'**il comprend deux cavités résonnantes, lesdites cavités étant fortement couplées par un miroir de couplage de sorte à lever la dégénerescence des modes de cavité résonnante dans lesdites cavités, lesdites cavités étant agencées pour générer trois fréquences paramétriques associées à ladite fréquences de pompe, ledit système comprenant deux miroirs qui ferment le système et qui forment lesdites cavités avec ledit miroir de couplage.

4. Système de conversion paramétrique selon l'une quelconque des revendications précédentes, **caractérisé en ce que** ledit milieu non linéaire actif présente une susceptibilité de type χ⁽³⁾.

5. Système de conversion paramétrique selon l'une quelconque des revendications 1 à 3, **caractérisé en ce que** ledit milieu non linéaire actif présente une susceptibilité de type χ⁽²⁾.

6. Système de conversion paramétrique selon l'une quelconque des revendications précédentes, dans lequel ledit matériau actif est un puit quantique, un système de boîtes quantiques, ou un polymère.

7. Système de conversion paramétrique selon l'une des revendications précédentes, **caractérisé en ce que** ledit au moins un miroir de couplage est un miroir de Bragg.

8. Système de conversion paramétrique selon l'une des revendications précédentes, **caractérisé en ce que** ledit au moins un miroir de couplage est composé d'une couche diélectrique ou métallique possédant les paramètres de réflectivité adaptés à ladite conversion paramétrique.

9. Système de conversion paramétrique selon l'une des revendications précédentes pour la conversion paramétrique à partir d'une onde de pompe, **caractérisé en ce que** chacune desdites cavités est d'épaisseur sensiblement égale à un petit nombre entier de fois la demi longueur d'onde de l'onde de pompe que l'on désire convertir.

10. Système de conversion paramétrique selon l'une des revendications précédentes, **caractérisé en ce que** l'épaisseur d'au moins une cavité présente un gradient latéral.

11. Système de conversion paramétrique selon l'une des revendications précédentes, **caractérisé en ce qu'**il est de type vertical et **en ce que** l'épaisseur de la première cavité présente un gradient latéral dans une première direction, et la seconde cavité a une épaisseur présentant un gradient latéral dans une seconde direction différente de ladite première direction.

12. Système de conversion paramétrique selon l'une des revendications précédentes, **caractérisé en ce que** le coeur des cavités est épitaxié.

13. Système de conversion paramétrique selon l'une des revendications précédentes, **caractérisé en ce qu'**au moins un miroir de couplage est épitaxié.

14. Dispositif optique destiné à la réalisation de conversion paramétrique comprenant un système selon l'une quelconque des revendications précédentes, comprenant en outre un moyen d'injection d'une onde de pompe à une longueur d'onde de pompe, ledit moyen d'injection étant apte à injecter ladite onde de pompe sensiblement selon l'axe dudit système.

15. Dispositif optique selon la revendication 14, **caractérisé en ce que** ledit moyen d'injection est formé par une cavité solidaire dudit système et faiblement couplé à celui-ci par un miroir de couplage faible pour ladite longueur d'onde de pompe.

16. Utilisation d'un dispositif selon l'une quelconque des revendications 14 ou 15, pour la réalisation de conversions paramétriques.

## Claims

1. A monolithic system (S) for the parametric conversion from a pump wave to a pump frequency, the system being **characterised in that** it includes at least two resonant cavities (6, 7), said cavities being strongly coupled by at least one coupling mirror (3) so as to remove the degeneracy of the resonant cavity modes in said cavities, said cavities being so arranged so as to generate parametric frequencies associated with said pump frequency, at least one of said cavities including a non linear active medium, said at least one coupling mirror being so arranged that said parametric frequencies are located in the stop band of said at least one mirror for a direction of injection of said pump wave by the surface of said system.

2. A parametric conversion system (S) according to claim 1, **characterised in that** it includes three resonant cavities, said cavities being strongly coupled by two coupling mirrors so as to remove the degeneracy of the resonant cavity modes in said cavities, said cavities being so arranged as to generate three parametric frequencies associated with said pump frequency, said system including two mirrors which close the system and form said cavities with said two coupling mirrors.

3. A parametric conversion system (S) according to claim 1, **characterised in that** it includes two resonant cavities, said cavities being strongly coupled by a coupling mirror so as to remove the degeneracy of the resonant cavity modes in said cavities, said cavities being so arranged as to generate three parametric frequencies associated with said pump frequency, said system including two mirrors which close the system and which form said cavities with said coupling mirror.

4. A parametric conversion system according to any one of the preceding claims, **characterised in that** said non linear active medium has a susceptibility of the χ⁽³⁾ type.

5. A parametric conversion system according to any one of claims 1 to 3, **characterised in that** said non linear active medium has a susceptibility of the χ⁽²⁾ type.

6. A parametric conversion system according to any one of the preceding claims, wherein said active material is a quantum well, a system of quantum dots or a polymer.

7. A parametric conversion system according to any one of the preceding claims, **characterised in that** said at least one coupling mirror is a Bragg mirror.

8. A parametric conversion system according to any one of the preceding claims, **characterised in that** said at least one coupling mirror is composed of a dielectric or metallic layer having the reflectivity parameters adapted to said parametric conversion.

9. A parametric conversion system according to any one of the preceding claims for the parametric conversion from a pump wave, **characterised in that** each of said cavities has a thickness substantially equal to a small integer times half the wavelength of the pump wave which it is desired to convert.

10. A system of parametric conversion according to one of the preceding claims, **characterised in that** the thickness at least one cavity has a lateral gradient.

11. A system of parametric conversion according to one of the preceding claims, **characterised in that** it is of the vertical type and **in that** the thickness of the first cavity has a lateral gradient in a first direction and the second cavity has a thickness having a lateral gradient in a second direction different from said first direction.

12. A parametric conversion system according to one of the preceding claims, **characterised in that** the core of the cavities is epitaxial.

13. A system of parametric conversion according to one of the preceding claims, **characterised in that** at least one coupled mirror is epitaxial.

14. An optical device intended for the execution of a parametric conversion including a system according to any one of the preceding claims, further including pump wave injection means at a pump wavelength, said injection means being able to inject said pump wave substantially along the axis of said system.

15. An optical device according to claim 14, **characterised in that** said injection means is formed by a cavity integral with said system and weakly coupled thereto by a low coupling mirror for said pump wavelength.

16. The utilization of a device according to any one of claims 14 or 15 for the execution of parametric conversions.

## Patentansprüche

1. Monolithisches System für die parametrische Konversion ab einer Pumpenwelle in eine Pumpenfrequenz, wobei das System **dadurch gekennzeichnet ist, dass** es mindestens zwei Resonanzkammern (6, 7) umfasst, wobei die genannten Kammern über mindestens einen Koppelspiegel (3) gekoppelt sind, so dass die Entartung der Resonanzkammernmodi in den genannten Kammern aufgehoben wird, wobei die genannten Kammern vorgesehen sind, um parametrische Frequenzen zu generieren, die der genannten Pumpenfrequenz zugeordnet sind, wobei mindestens eine der genannten Kammern ein aktives nicht lineares Milieu umfasst, wobei der genannte mindestens eine Koppelspiegel so angeordnet ist, dass sich die genannten parametrischen Frequenzen im Sperrband des genannten mindestens einen Spiegels befinden für eine Einkopplungsrichtung der genannten Pumpenwelle über die Oberfläche des genannten Systems.

2. Parametrisches Konversionssystem gemäß Anspruch 1,
**dadurch gekennzeichnet, dass** es drei Resonanzkammern umfasst, wobei die genannten Kammern stark über zwei Koppelspiegel gekoppelt sind, so dass die Entartung der Resonanzkammernmodi in den genannten Kammern aufgehoben wird, wobei die genannten Kammern vorgesehen sind, um drei parametrische Frequenzen zu generieren, die der genannten Pumpenfrequenz zugeordnet sind, wobei das System zwei Spiegel umfasst, die das System schließen und die die genannten Kammern mit den beiden genannten Koppelspiegeln bilden.

3. Parametrisches Konversionssystem gemäß Anspruch 1,
**dadurch gekennzeichnet, dass** es zwei Resonanzkammern umfasst, wobei die genannten Kammern stark über einen Koppelspiegel gekoppelt sind, so dass die Entartung der Resonanzkammernmodi in den genannten Kammern aufgehoben wird, wobei die genannten Kammern vorgesehen sind, um drei parametrische Frequenzen zu generieren, die der genannten Pumpenfrequenz zugeordnet sind, wobei das System zwei Spiegel umfasst, die das System schließen und die die genannten Kammern mit dem genannten Koppelspiegel bilden.

4. Parametrisches Konversionssystem gemäß einem der vorigen Ansprüche, **dadurch gekennzeichnet, dass** das genannte aktive nicht lineare Milieu eine Empfindlichkeit vom Typ χ⁽³⁾ aufweist.

5. Parametrisches Konversionssystem gemäß einem der Ansprüche 1 bis 3, **dadurch gekennzeichnet, dass** das genannte aktive nicht lineare Milieu eine Empfindlichkeit vom Typ χ (2) aufweist.

6. Parametrisches Konversionssystem gemäß einem der vorigen Ansprüche, bei dem das genannte aktive Material eine quantische Senke, ein quantisches Schachtelsystem oder ein Polymer ist.

7. Parametrisches Konversionssystem gemäß einem der vorigen Ansprüche, **dadurch gekennzeichnet, dass** der genannte mindestens eine Koppelspiegel ein Bragg-Spiegel ist.

8. Parametrisches Konversionssystem gemäß einem der vorigen Ansprüche, **dadurch gekennzeichnet, dass** der genannte mindestens eine Koppelspiegel aus einer dielektrischen oder metallischen Schicht besteht, die über die Reflektionsparameter verfügt, die für die genannte parametrische Konversion geeignet sind.

9. Parametrisches Konversionssystem gemäß einem der vorigen Ansprüche, für die parametrische Konversion ab einer Wellenpumpe, **dadurch gekennzeichnet, dass** jede der genannten Kammern eine Dicke aufweist, die etwa eine kleine Ganzzahl mal die halbe Pumpenwelle hat, die man konvertieren möchte.

10. Parametrisches Konversionssystem gemäß einem der vorigen Ansprüche, **dadurch gekennzeichnet, dass** die Dicke mindestens einer Kammer einen lateralen Gradienten aufweist.

11. Parametrisches Konversionssystem gemäß einem der vorigen Ansprüche, **dadurch gekennzeichnet, dass** es von einem vertikalen Typ ist, und dass die Dicke der ersten Kammer einen lateralen Gradienten in einer ersten Richtung aufweist, und die zweite Kammer eine Dicke hat, die einen lateralen Gradienten in einer zweiten Richtung aufweist, die sich von der ersten Richtung unterscheidet.

12. Parametrisches Konversionssystem gemäß einem der vorigen Ansprüche, **dadurch gekennzeichnet, dass** das Herz der Kammern epitaxisch ist.

13. Parametrisches Konversionssystem gemäß einem der vorigen Ansprüche, **dadurch gekennzeichnet, dass** mindestens ein Koppelspiegel eptitaxisch ist.

14. Optische Vorrichtung für die Durchführung der parametrischen Konversion mit einem System gemäß einem der vorigen Ansprüche, mit ferner einem Einkopplungsmittel einer Pumpenwelle mit einer Pumpenwellenlänge, wobei das genannte Einkopplungsmittel die genannte Pumpenwelle gemäß einer Achse des genannten Systems einkoppeln kann.

15. Optische Vorrichtung gemäß Anspruch 14, **dadurch gekennzeichnet, dass** das genannte Einkopplungsmittel aus einer an das System gebundene Kammer gebildet wird, und über einen für die genannte Pumpenwellenlänge schwachen Kopplungsspiegel schwach an das System gekoppelt ist.

16. Verwendung einer Vorrichtung gemäß einem der Ansprüche 14 oder 15 für die Durchführung von parametrischen Konversionen.
